(19) **Europäisches Patentamt / European Patent Office / Office européen des brevets**

(11) **EP 4 410 750 B1**

(12) # EUROPEAN PATENT SPECIFICATION

(45) Date of publication and mention
of the grant of the patent:
**10.12.2025 Bulletin 2025/50**

(21) Application number: **22929932.6**

(22) Date of filing: **31.10.2022**

(51) International Patent Classification (IPC):
**C03C 3/097** *(2006.01)*     **C03C 3/064** *(2006.01)*
**C03C 13/00** *(2006.01)*     **C08J 5/04** *(2006.01)*
**H05K 1/03** *(2006.01)*

(52) Cooperative Patent Classification (CPC):
**C08J 5/04; C03C 3/097; C03C 13/00; C03C 25/30;
C03C 25/40; C08J 5/043; H05K 1/0366;**
H05K 2201/0129; H05K 2201/0141;
H05K 2201/0145; H05K 2201/0154; H05K 2201/029

(86) International application number:
**PCT/JP2022/040584**

(87) International publication number:
**WO 2023/166788 (07.09.2023 Gazette 2023/36)**

(54) **GLASS COMPOSITION FOR GLASS FIBERS, GLASS FIBER, GLASS FIBER WOVEN FABRIC, AND GLASS-FIBER-REINFORCED RESIN COMPOSITION**

GLASZUSAMMENSETZUNG FÜR GLASFASERN, GLASFASER, GLASFASERGEWEBE UND GLASFASERVERSTÄRKTE HARZZUSAMMENSETZUNG

COMPOSITION DE VERRE POUR FIBRES DE VERRE, FIBRE DE VERRE, TISSU TISSÉ DE FIBRES DE VERRE ET COMPOSITION DE RÉSINE RENFORCÉE PAR FIBRES DE VERRE

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**

(30) Priority: **03.03.2022 JP 2022032970**

(43) Date of publication of application:
**07.08.2024 Bulletin 2024/32**

(73) Proprietor: **Nitto Boseki Co., Ltd.
Fukushima-shi
Fukushima 960-8161 (JP)**

(72) Inventors:
• **ITO, Jun
Fukushima-shi, Fukushima 960-8161 (JP)**
• **KURITA, Tadashi
Fukushima-shi, Fukushima 960-8161 (JP)**

• **NAKAMURA, Koichi
Fukushima-shi, Fukushima 960-8161 (JP)**
• **NONAKA, Takashi
Fukushima-shi, Fukushima 960-8161 (JP)**
• **HIRAYAMA, Norio
Narashino-shi, Chiba 275-8575 (JP)**
• **UNUMA, Hidero
Yonezawa-shi, Yamagata 992-8510 (JP)**

(74) Representative: **Dr. Schön, Neymeyr & Partner
Patentanwälte mbB
Bavariaring 26
80336 Munich (DE)**

(56) References cited:
WO-A1-2018/125736      WO-A1-2020/256143
GB-A- 2 016 441          JP-A- 2020 503 233
JP-A- 2021 178 764       JP-A- 2022 021 666
JP-A- 2022 021 666       JP-A- H04 228 455
JP-A- S52 107 015

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

Technical Field

The present invention relates to a glass composition for glass fiber, glass fiber, a glass fiber woven fabric, and a glass fiber-reinforced resin composition.

Background Art

Reduction in the weight, thickness, length, and size in printed wiring boards including a glass fiber-reinforced resin molded article, especially a glass fiber woven fabric has been under progress in recent years, and accordingly, extremely thin long glass fiber also has been demanded. For this reason, biosolubility will be considered to be an important property also for long glass fiber in the future. Thus, the present inventors have proposed a glass composition for glass fiber that comprises biosolubility and that can achieve long fiber formation (see Japanese Patent Application No. 2020-213162).

While a glass fiber-reinforced resin molded article has been increasingly used in a housing or component of an electronic device in recent years, glass generally absorbs the energy of an alternating current, as heat, and thus a problem is that, when the glass fiber-reinforced resin molded article is used in the housing or component of an electronic device, the housing or component generates heat.

The dielectric loss energy W absorbed by glass is here proportional to the dielectric constant $\varepsilon$ and the dielectric tangent $\tan\delta$ determined by the component and structure of glass, and is represented by the following formula (A).

$$W = kfv^2 \times \varepsilon^{1/2} \times \tan\delta \ ... \ (A)$$

In the formula (A), k represents a constant, f represents a frequency, and $v^2$ represents a potential gradient. It can be seen from the formula (A) that, as the dielectric constant $\varepsilon$ and the dielectric tangent $\tan\delta$ are larger and the frequency f is higher, the dielectric loss is larger and heat generated by the glass fiber-reinforced resin molded article is increased.

In recent years, as a result of an increase in the frequency (f in the formula (A)) of an alternating current applied to the electronic device, glass fiber comprising a lower dielectric constant $\varepsilon$ and a lower dielectric tangent $\tan\delta$ is known as glass fiber for use in the housing or component of the electronic device in order to reduce the dielectric loss energy W (e.g., see Patent Literature 1). Other low dielectric glass compositions, fibers and articles suitable for electronic devices can be found in Patent Literature 2.

Citation List

Patent Literature

Patent Literature 1: Japanese Patent No. 6927463
Patent Literature 2: WO 2018/125736

Summary of Invention

Technical Problem

Glass fiber including a glass filament formed of the glass composition for glass fiber described in Japanese Patent Application No. 2020-213162 comprises biosolubility and can achieve long fiber formation. However, it is disadvantageously impossible to allow the glass fiber to comprise a sufficiently low dielectric tangent in the case of use in a glass fiber-reinforced resin molded article to be placed under an environment affected by high frequencies.

An object of the present invention is to provide a glass composition for glass fiber, capable of providing glass fiber including a glass filament, which comprises biosolubility, which can achieve long fiber formation, and which also comprises a low dielectric tangent, by eliminating the disadvantage. Another object of the present invention is to provide glass fiber formed from the glass composition for glass fiber, and a glass fiber woven fabric and a glass fiber-reinforced resin composition each including the glass fiber.

Solution to Problem

In order to achieve the objects, the glass composition for glass fiber of the present invention includes $SiO_2$ in the range of 36.0% by mass or more and less than 48.0% by mass, $B_2O_3$ in the range of 18.0% by mass or more and 32.0% by mass or less, $Al_2O_3$ in the range of 12.0% by mass or more and 24.0% by mass or less, $P_2O_5$ in the range of 2.5% by mass or more and 8.9% by mass or less, and CaO and MgO in the range of 5.0% by mass or more and 13.0% by mass or less in total, with respect to the total amount.

The glass composition for glass fiber of the present invention, on formation of glass fiber, comprises biosolubility, can achieve long fiber formation, and can also comprise a low dielectric tangent, by comprising the above composition.

Here, the glass fiber comprising biosolubility means that the total elution rate of Si, B, Al and Ca, as measured by a method described below, is 110 $\mu$g/h or more. Achieving long fiber formation with respect to glass fiber means that the working temperature range calculated as the difference between 1000 poise temperature and liquid phase temperature, as measured by a method described below, is 30°C or more.

The glass fiber comprising a low dielectric tangent means that the dielectric tangent at a measurement frequency of 10 GHz is less than 0.0030.

In the glass composition for glass fiber of the present invention, the content S of $SiO_2$, the content P of $P_2O_5$, the content C of CaO and the content M of MgO in the glass composition for glass fiber, comprising the above composition, preferably satisfy the following formula (1-1):

$$0.38 \leq (C + M)/(S/P) \leq 1.52 \ldots (1\text{-}1)$$

The glass composition for glass fiber of the present invention, comprising the above composition, when the above S, P, C and M satisfy the formula (1-1), on formation of glass fiber, more certainly comprises biosolubility, can achieve long fiber formation, and can also comprise a low dielectric tangent.

In the glass composition for glass fiber of the present invention, the content S of $SiO_2$, the content B of $B_2O_3$, the content A of $Al_2O_3$, the content P of $P_2O_5$, the content C of CaO and the content M of MgO in the above composition preferably satisfy the following formula (2-1):

$$0.91 \leq (S/P) \times (C + M)/(A + B) \leq 2.31 \ldots (2\text{-}1)$$

The glass composition for glass fiber of the present invention, when the above S, B, A, P, C and M satisfy the formula (2-1) in the above composition, on formation of glass fiber, comprises biosolubility, easily achieves long fiber formation, and can also comprise a low dielectric tangent.

Here, easy achieving long fiber formation with respect to glass fiber means that the working temperature range calculated as the difference between 1000 poise temperature and liquid phase temperature, as measured by a method described below, is 100°C or more.

In the glass composition for glass fiber of the present invention, the above S, B, A, P, C and M in the glass composition for glass fiber, comprising the above composition, preferably satisfy the following formula (2-2):

$$0.92 \leq (S/P) \times (C + M)/(A + B) \leq 2.24 \ldots (2\text{-}2)$$

The glass composition for glass fiber of the present invention, when the above S, B, A, P, C and M satisfy the formula (2-2) in the glass composition for glass fiber, comprising the above composition, on formation of glass fiber, comprises biosolubility, easily achieves long fiber formation, can also comprise a low dielectric tangent, and furthermore can comprise excellent water resistance.

Here, glass fiber comprising excellent water resistance means that the mass reduction rate after a test of immersion of a fiber sample in water at 80°C for 24 hours is less than 1.0% by mass.

In the glass composition for glass fiber of the present invention, the above S, B, A, P, C and M in the glass composition for glass fiber, comprising the above composition, preferably satisfy the following formula (2-3):

$$0.93 \leq (S/P) \times (C + M)/(A + B) \leq 1.92 \ldots (2\text{-}3)$$

The glass composition for glass fiber of the present invention, when the above S, B, A, P, C and M satisfy the formula (2-3) in the glass composition for glass fiber, comprising the above composition, on formation of glass fiber, comprises biosolubility, easily achieves long fiber formation, can also comprise a low dielectric tangent, furthermore can comprise excellent water resistance, and can be suppressed in the occurrence of phase separation.

Here, suppressing the occurrence of phase separation with respect to glass fiber means that the appearance of a bulk for dielectric constant measurement, when observed, is transparent, or almost transparent with slight clouding.

The glass fiber of the present invention includes a glass filament formed of any of the above glass compositions for glass fiber. In the glass fiber of the present invention, the filament diameter of the glass filament is preferably less than 3.0 μm.

The glass fiber woven fabric of the present invention is formed of the above glass fiber.

The glass fiber-reinforced resin composition of the present invention includes the above glass fiber.

Description of Embodiments

Hereinafter, embodiments of the present invention will be described in detail.

The glass composition for glass fiber of the present embodiment includes $SiO_2$ in the range of 36.0% by mass or more and less than 48.0% by mass, $B_2O_3$ in the range of 18.0% by mass or more and 32.0% by mass or less, $Al_2O_3$ in the range of 12.0% by mass or more and 24.0% by mass or less, $P_2O_5$ in the range of 2.5% by mass or more and 8.9% by mass or less, and CaO and MgO in the range of 5.0% by mass or more and 13.0% by mass or less in total, with respect to the total amount.

The glass composition for glass fiber of the present embodiment, on formation of glass fiber, comprises biosolubility, can achieve long fiber formation, and can also comprise a low dielectric tangent, by comprising the above composition.

In the glass composition for glass fiber of the present embodiment, when the content of $SiO_2$ is less than 36.0% by mass with respect to the total amount, the strength and elastic modulus of glass fiber obtained from the glass composition for glass fiber decrease, and thus, when the composition is used in a composite material with a resin, the effect of reinforcing the resin becomes insufficient. In contrast, when the content of $SiO_2$ is 48.0% by mass or more with respect to the total amount, the biosolubility of glass fiber obtained from the glass composition for glass fiber may be lowered.

In the glass composition for glass fiber of the present embodiment, the content of $SiO_2$ with respect to the total amount is preferably in the range of 37.0% by mass or more and 47.9% by mass or less, more preferably in the range of 38.0% by mass or more and 47.4% by mass or less, still more preferably in the range of 39.0% by mass or more and less than 45.0% by mass, particularly preferably in the range of 39.5% by mass or more and 44.9% by mass or less, markedly preferably in the range of 40.0% by mass or more and 44.8% by mass or less, and most preferably in the range of 40.5% by mass or more and 44.4% by mass or less.

In the glass composition for glass fiber of the present embodiment, when the content of $B_2O_3$ is less than 18.0% by mass with respect to the total amount, devitrification temperature of the molten glass increases, thus long fiber formation may become difficult, and the biosolubility of glass fiber obtained from the glass composition for glass fiber may be lowered. In contrast, when the content of $B_2O_3$ exceeds 32.0% by mass with respect to the total amount, phase separation occurs in the molten glass, and thus long fiber formation becomes difficult.

In the glass composition for glass fiber of the present embodiment, the content of $B_2O_3$ with respect to the total amount is preferably in the range of 20.5% by mass or more and 29.4% by mass or less, more preferably in the range of 21.0% by mass or more and 28.0% by mass or less, still more preferably in the range of 21.5% by mass or more and 27.0% by mass or less, particularly preferably in the range of 21.8% by mass or more and 25.9% by mass or less, markedly preferably in the range of 22.0% by mass or more and 24.9% by mass or less, and most preferably in the range of 23.0% by mass or more and 24.4% by mass or less.

In the glass composition for glass fiber of the present embodiment, when the content of $Al_2O_3$ is less than 12.0% by mass with respect to the total amount, the strength and elastic modulus of glass fiber obtained from the glass composition for glass fiber decrease, and thus, when the composition is used in a composite material with a resin, the effect of reinforcing the resin becomes insufficient. In contrast, when the content of $Al_2O_3$ exceeds 24.0% by mass with respect to the total amount, devitrification temperature of the molten glass increases, and thus long fiber formation may become difficult.

In the glass composition for glass fiber of the present embodiment, the content of $Al_2O_3$ with respect to the total amount is preferably in the range of 14.0% by mass or more and 23.0% by mass or less, more preferably in the range of 15.0% by mass or more and 22.0% by mass or less, still more preferably in the range of 16.0% by mass or more and 21.0% by mass or less, particularly preferably in the range of 17.0% by mass or more and 20.5% by mass or less, markedly preferably in the range of 17.5% by mass or more and 20.3% by mass or less, and most preferably in the range of 18.1% by mass or more and 19.9% by mass or less.

In the glass composition for glass fiber of the present embodiment, when the content of $P_2O_5$ is less than 2.5% by mass with respect to the total amount, it is impossible to reduce the dielectric tangent of glass fiber obtained from the glass composition for glass fiber and simultaneously make long fiber formation possible. In contrast, when the content of $P_2O_5$ exceeds 8.9% by mass with respect to the total amount, the working temperature range decreases due to increase in the liquid phase temperature and thus long fiber formation may become difficult.

In the glass composition for glass fiber of the present embodiment, the content of $P_2O_5$ with respect to the total amount is preferably in the range of 2.7% by mass or more and 8.5% by mass or less, more preferably in the range of 2.9% by mass or more and 8.3% by mass or less, still more preferably in the range of 3.1% by mass or more and 8.1% by mass or less, particularly preferably in the range of 4.0% by mass or more and 7.9% by mass or less, markedly preferably in the range of 5.0% by mass or more and 7.7% by mass or less, and most preferably in the range of 5.5% by mass or more and 7.5% by mass or less.

In the glass composition for glass fiber of the present invention, when the content of CaO and MgO in total is less than 5.0% by mass with respect to the total amount, the biosolubility of glass fiber obtained from the glass composition for glass fiber may be lowered. In contrast, when the content of CaO and MgO in total exceeds 13.0% by mass with respect to the total amount, devitrification temperature of the molten glass increases, and thus long fiber formation may become difficult.

In the glass composition for glass fiber of the present embodiment, the total content of CaO and MgO with respect to the total amount is preferably in the range of 5.5% by mass or more and 11.0% by mass or less, more preferably in the range of 5.7% by mass or more and 10.0% by mass or less, still more preferably in the range of 5.8% by mass or more and 9.0% by mass or less, particularly preferably in the range of 6.0% by mass or more and 8.5% by mass or less, markedly preferably in the range of 6.5% by mass or more and 8.0% by mass or less, and most preferably in the range of 6.7% by mass or more and 7.5% by mass or less.

Here, the content of CaO with respect to the total amount is, for example, in the range of 2.0% by mass or more and 8.0% by mass or less, preferably in the range of 2.5% by mass or more and 7.5% by mass or less, more preferably in the range of 3.0% by mass or more and 7.0% by mass or less, still more preferably in the range of 3.5% by mass or more and 6.5% by mass or less, particularly preferably in the range of 4.0% by mass or more and 6.0% by mass or less, markedly preferably in the range of 4.2% by mass or more and 5.8% by mass or less, and most preferably in the range of 4.5% by mass or more and 5.5% by mass or less.

The content of MgO with respect to the total amount is, for example, in the range of 5.0% by mass or less, preferably in the range of 0.5% by mass or more and 4.0% by mass or less, more preferably in the range of 0.8% by mass or more and 3.5% by mass or less, still more preferably in the range of 1.0% by mass or more and 3.0% by mass or less, particularly preferably in the range of 1.1% by mass or more and 2.9% by mass or less, markedly preferably in the range of 1.3% by mass or more and 2.7% by mass or less, and most preferably in the range of 1.5% by mass or more and 2.5% by mass or less.

In the glass composition for glass fiber of the present embodiment, the content S of $SiO_2$, the content P of $P_2O_5$, the content C of CaO and the content M of MgO preferably satisfy the following formula (1-1):

$$0.38 \leq (C + M)/(S/P) \leq 1.52 \ldots (1\text{-}1)$$

The glass composition for glass fiber of the present embodiment, comprising the above composition, when the above S, P, C and M satisfy the formula (1-1), on formation of glass fiber, more certainly comprises biosolubility, can achieve long fiber formation, and can also comprise a low dielectric tangent.

Here, there is a tendency that, as the "C + M" in the formula (1-1) is higher, long fiber formation is facilitated and the biosolubility of glass fiber obtained from the glass composition for glass fiber increases, but the dielectric tangent of glass fiber obtained from the glass composition for glass fiber increases. In this regard, there is a tendency that, as the value of "S/P" is higher, the dielectric tangent of glass fiber obtained from the glass composition for glass fiber decreases, but long fiber formation becomes difficult and the biosolubility of glass fiber obtained from the glass composition for glass fiber decreases. It is presumed that the formula (1-1) expresses a scope in which glass fiber formed comprises biosolubility, can achieve long fiber formation and can also comprise a low dielectric tangent, in consideration of these conflicting tendencies.

In the glass composition for glass fiber of the present embodiment, the above S, P, C and M more preferably satisfy the following formula (1-2) and still more preferably satisfy the following formula (1-3).

$$0.55 \leq (C + M)/(S/P) \leq 1.50 \ldots (1\text{-}2)$$

$$0.87 \leq (C + M)/(S/P) \leq 1.36 \ldots (1\text{-}3)$$

The glass composition for glass fiber of the present embodiment, preferably, when the content S of $SiO_2$, the content B of $B_2O_3$, the content A of $Al_2O_3$, the content P of $P_2O_5$, the content C of CaO and the content M of MgO satisfy, for example, the following formula (2-0) in the above composition, comprises biosolubility, can achieve long fiber formation, and can more certainly comprise a low dielectric tangent:

$$0.77 \leq (S/P) \times (C + M)/(A + B) \leq 2.43 \ ... \ (2\text{-}0)$$

In the glass composition for glass fiber of the present embodiment, the above S, B, A, P, C and M in the composition more preferably satisfy the following formula (2-1), still more preferably satisfy the following formula (2-2), in particularly, preferably satisfy the following formula (2-3), especially preferably satisfy the following formula (2-4), particularly preferably satisfy the following formula (2-5), markedly preferably satisfy formula (2-6), and most preferably satisfy formula (2-7).

$$0.91 \leq (S/P) \times (C + M)/(A + B) \leq 2.31 \ ... \ (2\text{-}1)$$

$$0.92 \leq (S/P) \times (C + M)/(A + B) \leq 2.24 \ ... \ (2\text{-}2)$$

$$0.93 \leq (S/P) \times (C + M)/(A + B) \leq 1.92 \ ... \ (2\text{-}3)$$

$$0.97 \leq (S/P) \times (C + M)/(A + B) \leq 1.61 \ ... \ (2\text{-}4)$$

$$0.97 \leq (S/P) \times (C + M)/(A + B) \leq 1.41 \ ... \ (2\text{-}5)$$

$$1.10 \leq (S/P) \times (C + M)/(A + B) \leq 1.41 \ ... \ (2\text{-}6)$$

$$1.22 \leq (S/P) \times (C + M)/(A + B) \leq 1.41 \ ... \ (2\text{-}7)$$

The glass composition for glass fiber of the present embodiment, when the formula (2-5) is satisfied, on formation of glass fiber, comprises more excellent biosolubility, easily achieves long fiber formation, can also comprise a low dielectric tangent, furthermore can comprise excellent water resistance, and can be suppressed in the occurrence of phase separation. Here, comprising more excellent biosolubility means that the total elution rate of Si, B, Al and Ca is 120 $\mu$g/h or more.

The glass composition for glass fiber of the present embodiment, when the formula (2-6) is satisfied, on formation of glass fiber, comprises more excellent biosolubility, easily achieves long fiber formation, can also comprise a low dielectric tangent and a low dielectric constant, furthermore can comprise excellent water resistance, and can be suppressed in the occurrence of phase separation. Here, comprising a low dielectric constant means that the dielectric constant at a measurement frequency of 10 GHz is 4.50 or less.

In the glass composition for glass fiber of the present embodiment, the above S, B, A, C and M in the composition preferably satisfy the following formula (3), more preferably satisfy the following formula (4), still more preferably satisfy the following formula (5), and particularly preferably satisfy the following formula (6):

$$4.0 \leq S \times (C + M)/(A + B) < 11.3 \ ... \ (3)$$

$$5.9 \leq S \times (C + M)/(A + B) \leq 9.9 \ ... \ (4)$$

$$6.6 \leq S \times (C + M)/(A + B) < 9.2 \ ... \ (5)$$

$$6.6 \leq S \times (C + M)/(A + B) < 8.3 \ ... \ (6)$$

The glass composition for glass fiber of the present embodiment may include $TiO_2$, and when the composition includes $TiO_2$, the content of $TiO_2$ with respect to the total amount is, for example, in the range of 3.0% by mass or less, preferably in the range of 1.0% by mass or less, more preferably in the range of 0.4% by mass or less, still more preferably in the range of 0.2% by mass or less, particularly preferably in the range of 0.1% by mass or less, and most preferably in the range of 0.001% by mass or less.

The glass composition for glass fiber of the present embodiment may also include $Fe_2O_3$, from the viewpoint of improving the deaeration ability of the molten glass and improving stability of long fiber formation. When the composition includes $Fe_2O_3$, the content of $Fe_2O_3$ with respect to the total amount is, for example, in the range of 3.0% by mass or less, preferably in the range of 1.0% by mass or less, more preferably in the range of 0.4% by mass or less, still more preferably in the range of 0.2% by mass or less, particularly preferably in the range of 0.1% by mass or less, and most preferably in the range of 0.001% by mass or less.

The glass composition for glass fiber of the present embodiment may also include $ZrO_2$, from the viewpoint of lowering the melt viscosity of the molten glass and facilitating long fiber formation. When the composition includes $ZrO_2$, the content of $ZrO_2$ with respect to the total amount is, for example, in the range of 3.0% by mass or less, preferably in the range of 1.0% by mass or less, more preferably in the range of 0.4% by mass or less, still more preferably in the range of 0.2% by mass or less, particularly preferably in the range of 0.1% by mass or less, and most preferably in the range of 0.001% by mass or less.

The glass composition for glass fiber of the present embodiment may also include $F_2$ and $Cl_2$, from the viewpoint of improving the deaeration ability of the molten glass and improving stability of long fiber formation. When the composition includes $F_2$ and $Cl_2$, the content of $F_2$ and $Cl_2$ in total with respect to the total amount is, for example, in the range of 3.0% by mass or less, preferably in the range of 1.0% by mass or less, more preferably in the range of 0.4% by mass or less, still more preferably in the range of 0.2% by mass or less, particularly preferably in the range of 0.1% by mass or less, and most preferably in the range of 0.001% by mass or less.

The glass composition for glass fiber of the present embodiment may also include $SnO_2$, from the viewpoint of suppressing increase in the devitrification temperature of the molten glass and facilitating long fiber formation. When the composition includes $SnO_2$, the content of $SnO_2$ with respect to the total amount is, for example, in the range of 3.0% by mass or less, preferably in the range of 1.0% by mass or less, more preferably in the range of 0.4% by mass or less, still more preferably in the range of 0.2% by mass or less, particularly preferably in the range of 0.1% by mass or less, and most preferably in the range of 0.001% by mass or less.

The glass composition for glass fiber of the present embodiment may also include ZnO, from the viewpoint of suppressing increase in the devitrification temperature of the molten glass and facilitating long fiber formation. When the composition includes ZnO, the content of ZnO with respect to the total amount is, for example, in the range of 3.0% by mass or less, preferably in the range of 1.0% by mass or less, more preferably in the range of 0.4% by mass or less, still more preferably in the range of 0.2% by mass or less, particularly preferably in the range of 0.1% by mass or less, and most preferably in the range of 0.001% by mass or less.

Further, in the glass composition for glass fiber of the present embodiment, the total content of $SiO_2$, $B_2O_3$, $Al_2O_3$, CaO, MgO, and $P_2O_5$ is, for example, 91.0% by mass or more, preferably 95.0% by mass or more, more preferably 98.0% by mass or more, still more preferably 99.0% by mass or more, especially preferably 99.3% or more by mass, particularly preferably 99.5% by mass or more, markedly preferably 99.7% by mass or more, and most preferably 99.9% by mass or more, with respect to the total amount.

The glass composition for glass fiber of the present embodiment may include, as impurities attributable to raw materials, oxides of Li, K, Na, Ba, Mn, Co, Ni, Cu, Cr, Mo, W, Ce, Y, La, Bi, Gd, Pr, Sc, or Yb in the range of less than 3.0% by mass in total, with respect to the total amount of the glass composition for glass fiber, preferably in the range of less than 2.0% by mass, and more preferably in the range of less than 1.0% by mass. Particularly, when the glass composition for glass fiber of the present embodiment includes $Li_2O$, $K_2O$, $Na_2O$, BaO, $CeO_2$, $Y_2O_3$, $La_2O_3$, $Bi_2O_3$, $Gd_2O_3$, $Pr_2O_3$, $Sc_2O_3$, or $Yb_2O_3$, as impurities, the content of each of the impurities is independently preferably in the range of less than 0.40% by mass, more preferably in the range of less than 0.20% by mass, still more preferably in the range of less than 0.10% by mass, particularly preferably in the range of less than 0.05% by mass, and most preferably in the range of less than 0.01% by mass.

Regarding measurement of the content of each component described above in the glass composition for glass fiber of the present embodiment, the content of Li as the light element can be measured with an ICP emission spectroscopic analyzer. The contents of the other elements can be measured with a wavelength dispersive X-ray fluorescence analyzer.

Examples of the measurement method can include the following. First, a glass batch is placed in a platinum crucible, and melted with stirring while being held at a temperature of 1550°C for 4 hours in an electric furnace to obtain a homogeneous molten glass. Alternatively, glass fiber is placed in a platinum crucible, and melted with stirring while being held at a temperature of 1600°C for 4 hours in an electric furnace to obtain a homogeneous molten glass.

The glass batch is prepared by mixing a glass raw material. When organic matter adheres to the surface of the glass fiber, or when the glass fiber is mainly included as a reinforcing material in organic matter (resin), the glass fiber is used after the organic matter is removed by, for example, heating for a period in the range of about 0.5 to 24 hours in a muffle furnace at a temperature in the range of 300 to 650°C.

Next, the obtained molten glass is poured onto a carbon plate to produce a glass cullet, and then the glass cullet is pulverized and powdered into glass powder.

Then, regarding Li as a light element, the glass powder is thermally decomposed with an acid and then quantitatively analyzed using an ICP emission spectroscopic analyzer. Regarding other elements, the glass powder is molded into a disc shape by a pressing machine and then quantitatively analyzed using a wavelength dispersive X-ray fluorescence analyzer. The quantitative analysis with a wavelength dispersive X-ray fluorescence analyzer can be made by, specifically, producing a specimen for calibration curve based on the results measured by a fundamental parameter method, and performing analysis by a calibration curve method. The content of each component in the specimen for calibration curve can be quantitatively analyzed by an ICP emission spectroscopic analyzer. These quantitative analysis results are converted in terms of oxides to calculate the content of each component and the total amount, and the above content (% by mass) of each component can be determined from these numerical values.

Then, the glass fiber of the present embodiment includes a glass filament formed of the above glass composition for glass fiber of the present embodiment.

The glass fiber of the present embodiment is manufactured as follows. First, a glass raw material is prepared to have the composition of the glass composition for glass fiber of the present embodiment, based on components included in ores to be the glass raw material and the content of each component and the amount of each component volatilized in the melting process. Next, the prepared glass raw material (glass batch) is supplied to a melting furnace and melted at a temperature in the range of 1450 to 1600°C, for example. Then, the molten glass batch (molten glass) is drawn from 1 to 20000 nozzle tips of a bushing controlled at a predetermined temperature and rapidly cooled to form glass filaments.

When the glass composition for glass fiber of the present embodiment is melted at a temperature within the above range for manufacturing the above glass fiber, long fiber formation can be achieved when the working temperature range $\Delta T$ is 30°C or more and long fiber formation is facilitated when $\Delta T$ is 100°C or more. The working temperature range $\Delta T$ is calculated from the 1000 poise temperature and the liquid phase temperature by "$\Delta T = 1000$ poise temperature - liquid phase temperature".

Glass single fiber (glass filament) discharged from one nozzle tip or hole, cooled and solidified typically has a perfect circle cross-sectional shape and preferably has a diameter (filament diameter) in the range of less than 3.0 $\mu$m. On the other hand, when the above nozzle tip has a non-circular shape and has a protrusion or a notch for rapidly cooling the molten glass, controlling the temperature condition can provide a glass filament having a non-circular (e.g., elliptical or long-oval) cross-sectional shape. When the glass filament has an elliptical or long-oval cross-sectional shape, a fiber diameter when the cross-sectional area is converted to a perfect circle (converted fiber diameter), is preferably in the range of less than 3.0 $\mu$m. The lower limit value of the above filament diameter is, for example, 0.5 $\mu$m, preferably 1.0 $\mu$m, and more preferably 2.0 $\mu$m.

Subsequently, the glass filaments formed are applied with a sizing agent or binder using an applicator as an application apparatus. While 1 to 20000 of the glass filaments are bundled using a bundling shoe, the glass filaments are wound on a tube at a high speed using a winding apparatus to obtain glass fiber.

The glass fiber of the present embodiment may be coated with an organic matter on the surface thereof for the purposes such as improvement of glass filament convergence, improvement of adhesiveness between glass fiber and a resin, and improvement of uniform dispersibility of glass fiber in a mixture of glass fiber and resin or inorganic material. Examples of such an organic matter can include starch, urethane resins, epoxy resins, vinyl acetate resins, acrylic resins, modified polypropylene (particularly carboxylic acid-modified polypropylene), and a copolymer of (poly)carboxylic acid (particularly maleic acid) and an unsaturated monomer. The glass fiber of the present embodiment may be coated with the resin composition including a silane coupling agent, a lubricant, surfactant, and the like in addition to these resins.

The glass fiber of the present embodiment may be coated with the treating agent composition not including the above resins and including a silane coupling agent, surfactant, and the like. Such a resin composition or treating agent composition covers the glass fiber at a rate of 0.03 to 2.0% by mass based on the mass of the glass fiber of the present embodiment in a state where it is not coated with the resin composition or the treating agent composition. The glass fiber can be coated with an organic matter by applying a resin solution or a resin composition solution to the glass fiber using a known method such as a roller applicator, for example, in the manufacturing process of the glass fiber and then drying the glass fiber to which the resin solution or the resin composition solution is applied. The glass fiber of the present embodiment can also be coated with an organic matter by immersing the glass fiber in the form of a woven fabric in the treating agent composition solution and then drying the glass fiber to which the treating agent composition is applied.

Here, examples of the silane coupling agent include aminosilanes, ureidosilanes, chlorosilanes, epoxysilanes, mercaptosilanes, vinylsilanes, (meth)acrylsilanes, phenylsilanes, styrylsilanes, and isocyanate silanes.

Examples of the above aminosilane include $\gamma$-aminopropyltriethoxysilane, N-$\beta$-(aminoethyl)-$\gamma$-aminopropyltrimethoxysilane, N-$\beta$-(aminoethyl)-N'-$\beta$-(aminoethyl)-y-aminopropyltrimethoxysilane, and $\gamma$-anilinopropyltrimethoxysilane.

Examples of the ureidosilane include $\gamma$-ureidopropyltriethoxysilane and chlorosilane (y-chloropropyltrimethoxysilane).

Examples of the above epoxysilane include $\beta$-(3,4 - epoxycyclohexyl)ethyltrimethoxysilane and $\gamma$-glycidoxypropyltrimethoxysilane.

Examples of the above mercaptosilane include $\gamma$-mercaptotrimethoxysilane and $\gamma$-mercaptopropyltrimethox-

ysilane.

Examples of the above vinylsilane include vinyltrimethoxysilane, N-β-(N-vinylbenzylaminoethyl)-γ-aminopropyltrimethoxysilane, and N-benzyl-β-aminoethyl-γ-aminopropyltrimethoxysilane.

Examples of the above (meth)acrylsilane include γ-acryloxypropyltrimethoxysilane and γ-methacryloxypropyltrimethoxysilane.

Examples of the above phenylsilane include phenyltrimethoxysilane.

Examples of the above styrylsilane include p-styryltrimethoxysilane.

Examples of the above isocyanate silane include γ-isocyanate propyltriethoxysilane.

In the present embodiment, the silane coupling agents may be used singly or in combination of two or more.

Examples of the lubricant include modified silicone oils, animal oils and hydrogenated products thereof, vegetable oils and hydrogenated products thereof, animal waxes, vegetable waxes, mineral waxes, condensates of a higher saturated fatty acid and a higher saturated alcohol, polyethyleneimine, polyalkylpolyamine alkylamide derivatives, fatty acid amides, and quaternary ammonium salts.

Examples of the above animal oil include beef tallow.

Examples of the above vegetable oil include soybean oil, coconut oil, rapeseed oil, palm oil, and castor oil.

Examples of the above animal wax include beeswax and lanolin.

Examples of the above vegetable wax include candelilla wax and carnauba wax.

Examples of the above mineral wax include paraffin wax and montan wax.

Examples of the above condensate of a higher saturated fatty acid and a higher saturated alcohol include stearates such as lauryl stearate.

Examples of the above fatty acid amide include dehydrated condensates of polyethylenepolyamines such as diethylenetriamine, triethylenetetramine, and tetraethylenepentamine and fatty acids such as lauric acid, myristic acid, palmitic acid, and stearic acid.

Examples of the above quaternary ammonium salt include alkyltrimethylammonium salts such as lauryltrimethylammonium chloride.

In the present embodiment, the lubricants may be used singly or in combination of two or more.

Examples of the surfactant include nonionic surfactants, cationic surfactants, anionic surfactants, and amphoteric surfactants.

Examples of the above nonionic surfactant include ethylene oxide propylene oxide alkyl ether, polyoxyethylene alkyl ether, polyoxyethylene-polyoxypropylene-block copolymer, alkyl polyoxyethylene-polyoxypropylene block copolymer ether, polyoxyethylene fatty acid ester, polyoxyethylene fatty acid monoester, polyoxyethylene fatty acid diester, polyoxyethylene sorbitan fatty acid ester, glycerol fatty acid ester ethylene oxide adduct, polyoxyethylene castor oil ether, hydrogenated castor oil ethylene oxide adduct, alkylamine ethylene oxide adduct, fatty acid amide ethylene oxide adduct, glycerol fatty acid ester, polyglycerol fatty acid ester, pentaerythritol fatty acid ester, sorbitol fatty acid ester, sorbitan fatty acid ester, sucrose fatty acid ester, polyhydric alcohol alkyl ether, fatty acid alkanolamide, acetylene glycol, acetylene alcohol, ethylene oxide adduct of acetylene glycol, and ethylene oxide adduct of acetylene alcohol.

Examples of the above cationic surfactant include alkyldimethylbenzylammonium chloride, alkyltrimethylammonium chloride, alkyl dimethyl ethyl ammonium ethyl sulfate, higher alkylamine acetate, higher alkylamine hydrochloride, adduct of ethylene oxide to a higher alkylamine, condensate of a higher fatty acid and polyalkylene polyamine, a salt of an ester of a higher fatty acid and alkanolamine, a salt of higher fatty acid amide, imidazoline cationic surfactant, and alkyl pyridinium salt.

Examples of the above anionic surfactant include higher alcohol sulfate salts, higher alkyl ether sulfate salts, α-olefin sulfate salts, alkylbenzene sulfonate salts, α-olefin sulfonate salts, reaction products of fatty acid halide and N-methyl taurine, dialkyl sulfosuccinate salts, higher alcohol phosphate ester salts, and phosphate ester salts of higher alcohol ethylene oxide adduct.

Examples of the above amphoteric surfactant include amino acid amphoteric surfactants, betaine amphoteric surfactants such as alkyldimethylbetaine, and imidazoline amphoteric surfactants.

Examples of such amino acid amphoteric surfactants include alkali metal salts of alkylaminopropionic acid.

In the present embodiment, the surfactants may be used singly or in combination of two or more.

The dielectric tangent at a measurement frequency of 10 GHz of the glass fiber of the present embodiment is in the range of less than 0.0030, preferably in the range of 0.0011 to 0.0029, more preferably in the range of 0.0015 to 0.0028, still more preferably in the range of 0.0019 to 0.0027, particularly preferably in the range of 0.0020 to 0.0027, and most preferably in the range of 0.0021 to 0.0026.

The dielectric constant at a measurement frequency of 10 GHz of the glass fiber of the present embodiment is in the range of less than 5.20, preferably in the range of 4.00 to 5.00, more preferably in the range of 4.10 to 4.90, still more preferably in the range of 4.15 to 4.80, especially preferably in the range of 4.20 to 4.70, particularly preferably in the range of 4.25 to 4.65, markedly preferably in the range of 4.31 to 4.60, and most preferably in the range of 4.32 to 4.44. The dielectric constant of the glass fiber of the present embodiment can be measured using the same test piece and measurement apparatus as those in a dielectric tangent measurement method described below, in accordance with JIS C 2565:1992.

The total elution rate of Si, B, Al and Ca in the glass fiber of the present embodiment is in the range of 110 μg/h or more, preferably in the range of 110 to 500 μg/h, more preferably in the range of 120 to 400 μg/h, and still more preferably in the range of 130 to 300 μg/h.

Next, the glass fiber woven fabric of the present embodiment is formed of the above glass fiber of the present embodiment. The glass fiber woven fabric of the present embodiment can be obtained by weaving the above glass fiber of the present embodiment as warp yarns and weft yarns using a loom known per se. Examples of the loom may include jet looms such as air jet or water jet looms, shuttle looms, and rapier looms. Examples of weaving with the loom may include plain weaving, satin weaving, mat weaving, and twill weaving. From the viewpoint of production efficiency, plain weaving is preferred.

The above glass fiber of the present embodiment included in the glass fiber woven fabric of the present embodiment is preferably formed of glass filaments comprising a filament diameter in the range of 2.0 μm or more and 9.0 μm or less and comprises a mass in the range of 0.35 to 70.0 tex (g/1000 m) and is more preferably formed of glass filaments comprising a filament diameter in the range of 2.0 μm or more and less than 3.0 μm and comprises a mass in the range of 0.35 to 1.5 tex.

Here, the filament diameter of the above glass fiber of the present embodiment included in the glass fiber woven fabric of the present embodiment is the average value of measurements when the diameter of the glass filaments constituting the above glass fiber is measured on at least 50 cross sections of the above glass fiber with a scanning electron microscope (manufactured by Hitachi High-Tech Corporation, trade name: S-3400N, magnification: 3000 times).

The glass fiber woven fabric of the present embodiment is preferably constituted by warp yarns comprising a weaving density in the range of 40 to 150 yarns/25 mm and weft yarns comprising a weaving density in the range of 40 to 150 yarns/25 mm.

The glass fiber woven fabric of the present embodiment, after woven, may be subjected to desizing treatment, surface treatment, and opening treatment.

An example of the desizing treatment is a treatment including placing the glass fiber woven fabric in a heating oven having an atmosphere temperature in the range of 350°C to 400°C for a period in the range of 40 to 80 hours to thereby pyrolytically decompose organic matter adhering to the glass fiber.

An example of the surface treatment is a treatment including immersing the glass fiber woven fabric in a solution including the silane coupling agent or including the silane coupling agent and the surfactant, squeezing extra water therefrom, and heat-drying the woven fabric at a temperature in the range of 80 to 180°C for a period in the range of 1 to 30 minutes.

An example of the opening treatment is a treatment in which the warp yarns of the glass fiber woven fabric are subjected to opening by means of water flow pressure, opening by means of high-frequency vibration using a liquid as a medium, opening by means of the pressure of a fluid having a surface pressure, opening by means of pressing with a roll, or the like under a tension in the range of 20 to 200 N to thereby widen the width of the warp yarns and weft yarns.

The glass fiber woven fabric of the present embodiment has preferably a mass in the range of 2.5 to 220 g/m$^2$, and more preferably a thickness in the range of 4.0 to 200.0 μm.

The glass fiber woven fabric of the present embodiment may comprise a surface treatment layer including the silane coupling agent or the silane coupling agent and the surfactant. When the glass fiber woven fabric of the present embodiment includes the surface treatment layer, the surface treatment layer can have a mass in the range of 0.03 to 1.50% by mass, for example, with respect to the total amount of the glass fiber woven fabric including the surface treatment layer.

The glass fiber-reinforced resin composition of the present embodiment includes the above glass fiber of the present embodiment. Specifically, the glass fiber-reinforced resin composition of the present embodiment includes glass fiber in the range of 10 to 90% by mass with respect to the total amount of the glass fiber-reinforced resin composition, as the glass fiber-reinforced resin composition including resin (thermoplastic resin or thermosetting resin), glass fiber, and other additives. The glass fiber-reinforced resin composition of the present embodiment includes a resin in the range of 90 to 10% by mass and includes other additives in the range of 0 to 40% by mass with respect to the total amount of the glass fiber-reinforced resin composition.

Examples of the above thermoplastic resin can include polyethylene, polypropylene, polystyrene, styrene/maleic anhydride resins, styrene/maleimide resins, polyacrylonitrile, acrylonitrile/styrene (AS) resins, acrylonitrile/butadiene/styrene (ABS) resins, chlorinated polyethylene/acrylonitrile/styrene (ACS) resins, acrylonitrile/ethylene/styrene (AES) resins, acrylonitrile/styrene/methyl acrylate (ASA) resins, styrene/acrylonitrile (SAN) resins, methacrylic resins, polyvinyl chloride (PVC), polyvinylidene chloride (PVDC), polyamide, polyacetal, polyethylene terephthalate (PET), polybutylene terephthalate (PBT), polytrimethylene terephthalate (PTT), polycarbonate, polyarylene sulfide, polyethersulfone (PES), polyphenylsulfone (PPSU), polyphenylene ether (PPE), modified polyphenylene ether (m-PPE), polyaryl etherketone, liquid crystal polymer (LCP), fluororesins, polyetherimide (PEI), polyarylate (PAR), polysulfone (PSF), polyamideimide (PAI), polyaminobismaleimide (PABM), thermoplastic polyimide (TPI), polyethylene naphthalate (PEN), ethylene/vinyl acetate (EVA) resins, ionomer (IO) resins, polybutadiene, styrene/butadiene resins, polybutylene, polymethylpentene, olefin/vinyl alcohol resins, cyclic olefin resins, cellulose resins, and polylactic acid.

Specific examples of the above polyethylene include high density polyethylene (HDPE), medium density polyethylene, low density polyethylene (LDPE), linear low density polyethylene (LLDPE), and ultra high molecular weight polyethylene.

Examples of the above polypropylene include isotactic polypropylene, atactic polypropylene, syndiotactic polypropylene, and mixtures thereof.

Examples of the above polystyrene include general-purpose polystyrene (GPPS), which is an atactic polystyrene having an atactic structure, high impact polystyrene (HIPS) with a rubber component added to GPPS, and syndiotactic polystyrene with syndiotactic structure.

Examples of the above methacrylic resin include polymers obtained by homopolymerizing one of acrylic acid, methacrylic acid, styrene, methyl acrylate, ethyl acrylate, ethyl methacrylate, butyl acrylate, butyl methacrylate, and fatty acid vinyl ester, or polymers obtained by copolymerizing two or more of these.

Examples of the above polyvinyl chloride include a vinyl chloride homopolymer, a copolymer of a vinyl chloride monomer and a copolymerizable monomer, or a graft copolymer obtained by graft polymerization of a vinyl chloride monomer to polymer polymerized by a conventionally known method such as emulsion polymerization method, suspension polymerization method, micro suspension polymerization method, or bulk polymerization method.

Examples of the above polyamide can include one of components such as polycaproamide (nylon 6), polyhexamethylene adipamide (nylon 66), polytetramethylene adipamide (nylon 46), polytetramethylene sebacamide (nylon 410), polypentamethylene adipamide (nylon 56), polypentamethylene sebacamide (nylon 510), polyhexamethylene sebacamide (nylon 610), polyhexamethylene dodecamide (nylon 612), polydecamethylene adipamide (nylon 106), polydecamethylene sebacamide (nylon 1010), polydecamethylene dodecamide (Nylon 1012), polyundecanamide (Nylon 11), polyundecamethylene adipamide (Nylon 116), polydodecanamide (Nylon 12), polyxylene adipamide (nylon XD6), polyxylene sebacamide (nylon XD10), polymetaxylylene adipamide (nylon MXD6), polyparaxylylene adipamide (nylon PXD6), polytetramethylene terephthalamide (nylon 4T), polypentamethylene terephthalamide (nylon 5T), polyhexamethylene terephthalamide (nylon 6T), polyhexamethylene isophthalamide (nylon 6I), polynonamethylene terephthalamide (nylon 9T), polydecamethylene terephthalamide (nylon 10T), polyundecamethylene terephthalamide (nylon 11T), polydodecamethylene terephthalamide (nylon 12T), polytetramethylene isophthalamide (nylon 4I), polybis(3-methyl-4-aminohexyl) methane terephthalamide (nylon PACMT), polybis(3-methyl-4-aminohexyl) methane isophthalamide (nylon PACMI), polybis(3-methyl-4-aminohexyl) methane dodecamide (nylon PACM12), and polybis(3-methyl-4-aminohexyl) methane tetradecamide (nylon PACM14) or copolymers or mixtures of two or more of the components.

Examples of the above polyacetal include a homopolymer with oxymethylene units as the main repeating unit, and a copolymer mainly consisting of oxymethylene units and containing oxyalkylene units having 2 to 8 adjacent carbon atoms in the main chain.

Examples of the above polyethylene terephthalate include a polymer obtained by polycondensation of terephthalic acid or a derivative thereof with ethylene glycol.

Examples of the above polybutylene terephthalate include a polymer obtained by polycondensation of terephthalic acid or a derivative thereof with 1,4-butanediol.

Examples of the above polytrimethylene terephthalate include polymers obtained by polycondensation of terephthalic acid or a derivative thereof with 1,3-propanediol.

Examples of the above polycarbonate include polymers obtained by a transesterification method in which a dihydroxydiaryl compound is reacted with a carbonate such as diphenyl carbonate in a molten state; or polymers obtained by phosgene method in which a dihydroxaryl compound is reacted with phosgene.

Examples of the above polyarylene sulfide include linear polyphenylene sulfide, cross linked polyphenylene sulfide having a high molecular weight obtained by performing a curing reaction after polymerization, polyphenylene sulfide sulfone, polyphenylene sulfide ether, and polyphenylene sulfide ketone.

Examples of the above polyphenylene ether include poly(2,3-dimethyl-6-ethyl-1,4-phenylene ether), poly(2-methyl-6-chloromethyl-1,4-phenylene ether), poly(2-methyl-6-hydroxyethyl-1,4-phenylene ether), poly(2-methyl-6-n-butyl-1,4-phenylene ether), poly(2-ethyl-6-isopropyl-1,4-phenylene ether), poly(2-ethyl-6-n-propyl-1,4-phenylene ether), poly(2,3,6-trimethyl-1,4-phenylene ether), poly[2-(4'-methylphenyl)-1,4-phenylene ether], poly(2-bromo-6-phenyl-1,4-phenylene ether), poly(2-methyl-6-phenyl-1,4-phenylene ether), poly(2-phenyl-1,4-phenylene ether), poly(2-chloro-1,4-phenylene ether), poly(2-methyl-1,4-phenylene ether), poly(2-chloro-6-ethyl-1,4-phenylene ether), poly(2-chloro-6-bromo-1,4-phenylene ether), poly(2,6-di-n-propyl-1,4-phenylene ether), poly(2-methyl-6-isopropyl-1,4-phenylene ether), poly(2-chloro-6-methyl-1,4-phenylene ether), poly(2-methyl-6-ethyl-1,4-phenylene ether), poly(2,6-dibromo-1,4-phenylene ether), poly(2,6-dichloro-1,4-phenylene ether), poly(2,6-diethyl-1,4-phenylene ether), and poly(2,6-dimethyl-1,4-phenylene ether).

Examples of the above modified polyphenylene ether include: a polymer alloy of poly(2,6-dimethyl-1,4-phenylene)ether and polystyrene; a polymer alloy of poly(2,6-dimethyl-1,4-phenylene)ether and a styrene/butadiene copolymer; a polymer alloy of poly(2,6-dimethyl-1,4-phenylene)ether and a styrene/maleic anhydride copolymer; a polymer alloy of poly(2,6-dimethyl-1,4-phenylene)ether and polyamide; a polymer alloy of poly(2,6-dimethyl-1,4-phenylene)ether and styrene/butadiene/acrylonitrile copolymer; one obtained by introducing a functional group such as an amino group, an epoxy group, a carboxy group, a styryl group, or the like at the polymer chain end of the polyphenylene ether; and one obtained by introducing a functional group such as an amino group, an epoxy group, a carboxy group, a styryl group, a methacryl group, or the like at the polymer chain side chain of the polyphenylene ether.

Examples of the above polyaryl etherketone include polyetherketone (PEK), polyetheretherketone (PEEK), polyetherketoneketone (PEKK), and polyetheretherketoneketone (PEEKK).

Examples of the above liquid crystal polymer (LCP) include a polymer (copolymer) consisting of one or more structural units selected from aromatic hydroxycarbonyl units which are thermotropic liquid crystal polyesters, aromatic dihydroxy units, aromatic dicarbonyl units, aliphatic dihydroxy units, aliphatic dicarbonyl units, and the like.

Examples of the above fluororesin include polytetrafluoroethylene (PTFE), perfluoroalkoxy resins (PFA), fluorinated ethylene propylene resins (FEP), fluorinated ethylene tetrafluoroethylene resins (ETFE), polyvinyl fluoride (PVF), polyvinylidene fluoride (PVDF), polychlorotrifluoroethylene (PCTFE), and ethylene/chlorotrifluoroethylene resin (ECTFE).

Examples of the above ionomer (IO) resin include copolymers of an olefin or a styrene and an unsaturated carboxylic acid, wherein a part of carboxyl groups is neutralized with a metal ion.

Examples of the above olefin/vinyl alcohol resin include ethylene/vinyl alcohol copolymers, propylene/vinyl alcohol copolymers, saponified products of ethylene/vinyl acetate copolymers, and saponified products of propylene/vinyl acetate copolymers.

Examples of the above cyclic olefin resin include monocyclic compounds such as cyclohexene, polycyclic compounds such as tetracyclopentadiene, and polymers of cyclic olefin monomers.

Examples of the above polylactic acid include poly-L-lactic acid which is a homopolymer of L-form, poly-D-lactic acid which is a homopolymer of D-form, or a stereocomplex polylactic acid which is a mixture thereof.

Examples of the above cellulose resin can include methylcellulose, ethyl cellulose, hydroxycellulose, hydroxymethylcellulose, hydroxyethyl cellulose, hydroxyethyl methylcellulose, hydroxypropylmethylcellulose, cellulose acetate, cellulose propionate, and cellulose butyrate.

Examples of the above thermosetting resin can include unsaturated polyester resins, vinyl ester resins, epoxy (EP) resins, melamine (MF) resins, phenol resins (PF), urethane resins (PU), polyisocyanate, polyisocyanurate, modified polyimide (PI) resin, urea (UF) resins, silicone (SI) resins, furan (FR) resins, benzoguanamine (BR) resins, alkyd resins, xylene resins, bismaleimide triazine (BT) resins, and diallyl phthalate resin (PDAP).

Specific examples of the above unsaturated polyester resin include resin obtained by esterification reaction of aliphatic unsaturated dicarboxylic acid and aliphatic diol.

Examples of the above vinyl ester resin include bis vinyl ester resins and novolac vinyl ester resins.

Examples of the above epoxy resin include bisphenol A epoxy resins, bisphenol F epoxy resins, bisphenol E epoxy resins, bisphenol S epoxy resins, bisphenol M epoxy resins (4,4'-(1,3-phenylenediisopropylidene)bisphenol epoxy resins), bisphenol P epoxy resins (4,4'-(1,4-phenylenediisopropylidene)bisphenol epoxy resins), bisphenol Z epoxy resins (4,4'-cyclohexylidne bisphenol epoxy resins), phenol novolac epoxy resins, cresol novolac epoxy resins, tetraphenol group ethane novolac type epoxy resins, novolac epoxy resins having a condensed ring aromatic hydrocarbon structure, biphenyl epoxy resins, aralkyl epoxy resins such as xylylene epoxy resins and phenyl aralkyl epoxy resins, naphthylene ether epoxy resins, naphthol epoxy resins, naphthalene diol epoxy resins, bifunctional or tetrafunctional epoxy naphthalene resins, binaphthyl epoxy resins, naphthalene aralkyl epoxy resins, anthracene epoxy resins, phenoxy epoxy resins, dicyclopentadiene epoxy resins, norbornene epoxy resins, adamantane epoxy resins, and fluorene epoxy resins.

Examples of the above melamine resin include a polymer formed by polycondensation of melamine (2,4,6-triamino-1,3,5-triazine) and formaldehyde.

Examples of the above phenolic resin include novolac phenolic resins such as phenol novolac resins, cresol novolac resins, and bisphenol A novolac resins, resol phenol resins such as methylol resole resins and dimethylene ether resole resins, or aryl alkylene phenol resins, and include one of these or combinations of two or more.

Examples of the above urea resin include a resin obtained by condensation of urea and formaldehyde.

The above thermoplastic resin or the above thermosetting resin may be used singly or in combinations of two or more.

Examples of the above other additives can include reinforcing fiber other than glass fiber, a filler other than glass fiber, a flame retardant, an UV absorber, a heat stabilizer, an antioxidant, an antistatic agent, a fluidity improver, an antiblocking agent, a lubricant, a nucleating agent, an antibacterial agent, and pigment.

Examples of the reinforcing fiber other than glass fiber include carbon fiber and metal fiber.

Examples of the filler other than glass fiber include glass powder, talc, and mica.

The glass fiber-reinforced resin composition of the present embodiment may be prepreg obtained by impregnating the glass fiber woven fabric of the present embodiment with the resin by a known method per se and semi-curing the woven fabric.

The glass fiber-reinforced resin composition of the present embodiment can be molded by a known molding method such as injection molding method, injection compression molding method, two-color molding method, hollow molding method, foam molding method (also including supercritical fluid method), insert molding method, in-mold coating molding method, autoclave molding method, extrusion molding method, sheet molding method, thermal molding method, rotational molding method, laminate molding method, press molding method, blow molding method, stamping molding method, infusion method, hand lay-up method, spray-up method, low-pressure RIM molding method, resin transfer molding method, sheet molding compound method, bulk molding compound method, pultrusion method, or filament winding method to obtain various glass fiber-reinforced resin molded articles. Curing the prepreg can also provide glass fiber-reinforced resin molded articles.

Examples of applications of the molded article include printed wiring boards, electronic components (such as connectors), housings of electronic devices (such as antennas and radar), and separators of fuel cells.

Examples, Comparative Examples and Reference Example of the present invention will be shown.

Examples

[Example 1 to 6, Comparative Example 1 to 5 and Reference Example]

The biosolubility, the dielectric tangent, the working temperature range, the water resistance and the phase separation were evaluated by methods shown below. The results of Examples 1 to 6 are shown in Table 1, and the results of Comparative Examples 1 to 5 and Reference Example are shown in Table 2.

Glass fiber obtained from the glass composition for glass fiber of Example 1 had a dielectric tangent at a measurement frequency of 10 GHz, of 0.0026, a dielectric constant at a measurement frequency of 10 GHz, of 4.42, and a total elution rate of Si, B, Al and Ca of 141 $\mu$g/h.

Glass fiber obtained from the glass composition for glass fiber of Example 2 had a dielectric tangent at a measurement frequency of 10 GHz, of 0.0027, a dielectric constant at a measurement frequency of 10 GHz, of 4.51, and a total elution rate of Si, B, Al and Ca of 185 $\mu$g/h.

Glass fiber obtained from the glass composition for glass fiber of Example 3 had a dielectric tangent at a measurement frequency of 10 GHz, of 0.0023, a dielectric constant at a measurement frequency of 10 GHz, of 4.43, and a total elution rate of Si, B, Al and Ca of 115 $\mu$g/h.

[Biosolubility]

At first, glass raw material was mixed to obtain a glass batch so that the glass composition after melt-solidification is each composition of Examples 1 to 6 shown in Table 1 and Comparative Examples 1 to 5 and Reference Example shown in Table 2. Next, the obtained glass batch was placed in a platinum crucible. While this platinum crucible was held in an electric furnace for 4 hours under temperature conditions in the range of 1500 to 1600°C appropriate for melting of the glass batch of each of Examples, Comparative Examples and Reference Example, the glass batch was melted with stirring to obtain a homogeneous molten glass. Next, the obtained molten glass is poured onto a carbon plate and cooled to obtain bulk glass cullet.

Next, the obtained glass cullet was charged into a platinum container equipped with a nozzle tip at the bottom, and the platinum container was heated to a temperature in the range of 1150 to 1350°C to melt the glass cullet to thereby obtain molten glass. Then, the molten glass was drawn out through the nozzle tip and wound to a winding apparatus. Then, the heating temperature of the platinum container and the winding rate of the winding apparatus were adjusted, and the glass fiber was wound to the winding apparatus at a heating temperature in the range of 1150 to 1350°C appropriate for the glass composition of each of Examples, Comparative Examples and Reference Example and at a winding rate in the range of 800 to 1200 rpm appropriate for the glass composition of each of Examples, Comparative Examples and Reference Example to obtain a glass fiber sample having a filament diameter of 13.0 $\mu$m.

Next, in accordance with K. Sebastian. et al., Glass Science and Technology, Vol. 75, pp. 263-270 (2002), an artificial lung fluid of pH 4.5, which simulates the environment in the lungs, was prepared by sequentially adding Nos. 1 to 12 reagents shown below to about 800 mL of distilled water such that the final volume of 1 L was achieved while the pH was adjusted with No. 13 hydrochloric acid (1:1).

Nos. 1 to 12 reagents described above are as follows. No. 1: Sodium chloride, No. 2: Sodium hydrogen carbonate, No. 3: Calcium chloride, No. 4: Disodium hydrogen phosphate, No. 5: Sodium sulfate, No. 6: Magnesium chloride hexahydrate, No. 7: Glycine, No. 8: Trisodium citrate dihydrate, No. 9: Sodium tartrate dihydrate, No. 10: Sodium pyruvate, No. 11: 90% Lactic acid, No. 12: Formaldehyde.

As a result, 1 L of the artificial lung fluid comprises the composition of 7.12 g/L of sodium chloride, 1.95 g/L of sodium hydrogen carbonate, 0.022 g/L of calcium chloride, 0.143 g/L of disodium hydrogen phosphate, 0.079 g/L of sodium sulfate, 0.212 g/L of magnesium chloride hexahydrate, 0.118 g/L of glycine, 0.152 g/L of trisodium citrate dihydrate, 0.18 g/L of sodium tartrate dihydrate, 0.172 g/L of sodium pyruvate, 0.156 g/L of 90% lactic acid, 3 mL of formaldehyde, and 4 to 5 mL of hydrochloric acid (1:1).

Then, the prepared artificial lung fluid was allowed to stand for 24 hours. Then, in the artificial lung fluid after the standing, the pH had increased in association with release of carbonic gas, and thus the pH of the artificial lung fluid was adjusted to 4.5 again using hydrochloric acid.

Fiber taken in the lungs is known to be taken up by macrophages. As the pH around macrophages is 4.5, fiber having high solubility in the artificial lung fluid of pH 4.5 is expected to be dissolved inside the lungs.

Next, in accordance with K. Sebastian. et al., Glass Science and Technology, Vol. 75, pp. 263-270 (2002), the glass fiber sample was cut to a length of 1 to 3 mm, which length can fit to an in-line filter holder, and used as a glass fiber sample for elution test. An elution test was performed in such a manner that the above glass fiber sample for elution test was mounted on a membrane filter installed in an in-line filter holder, the above artificial lung fluid warmed to 37°C was pumped into the in-line filter holder at a flow rate in the range of 140 to 170 mL/day, and the filtrate that passed through the test glass fiber sample and the filter holder was stored in a container. At this time, the mass of the sample mounted on the membrane filter was adjusted such that the ratio of the flow rate of the artificial lung fluid (unit: $\mu m^3/s$) to the sample surface area (unit: $\mu m^2$) (flow rate of the artificial lung fluid/sample surface area) was $0.030 \pm 0.005$ $\mu m/s$. After the elapse of 24 hours, the filtrate was recovered from the container, Si, Al, B and Ca were taken as ions to be analyzed, ion components eluted in the filtrate were quantified using inductively coupled plasma atomic emission spectroscopy (ICP-AES), and the ICP-AES quantitative results of Si, Al, B and Ca ($\mu g$) were divided by 24 hours to calculate the elution rate ($\mu g/h$) of each component.

Next, the biosolubility was evaluated as "OK" when the total elution rate of Si, B, Al and Ca, as measured by the above method, was in the range of 110 $\mu g/h$ or more, and the biosolubility was evaluated as "NG" when the total elution rate of Si, B, Al and Ca, as measured by the above method, was in the range of less than 110 $\mu g/h$.

[Dielectric tangent]

At first, glass raw material was mixed to obtain a glass batch so that the glass composition after melt-solidification is each composition of Examples 1 to 6 shown in Table 1 and Comparative Examples 1 to 5 and Reference Example shown in Table 2. Next, the obtained glass batch was placed in a platinum crucible having a diameter of 80 mm and melted at a temperature in the range of 1500°C to 1600°C for 7 hours, and taken out from the crucible to obtain a glass bulk. Next, the obtained glass bulk was annealed at a temperature in the range of 580 to 700°C for 8 hours to obtain a test piece.

Next, the test piece was cut and polished to make a test piece polished of 80 mm × 3 mm (thickness 1 mm). Next, the obtained test piece polished was absolutely dried, and then stored in a room at 23°C and at a humidity of 60% for 24 hours. Next, the obtained test piece polished was subjected to measurement of the dielectric tangent (rate of dissipation Df) at 10 GHz with a dielectric constant measurement apparatus by cavity resonator method, ADMS01Oc1 (trade name) manufactured by AET, Inc., in accordance with JIS C 2565:1992.

Next, the dielectric tangent was evaluated as "OK" when the dielectric tangent as measured by the above method was in the range of less than 0.0030, and the dielectric tangent was evaluated as "NG" when the dielectric tangent as measured by the above method was in the range of 0.0030 or more.

[Working temperature range]

By use of a high temperature electric furnace equipped with a rotational viscometer (manufactured by Shibaura System Co. Ltd.), the glass cullet described above was melted in a platinum crucible, and the viscosity of the molten glass was continuously measured using the Brookfield rotational viscometer with the melt temperature varied. The temperature at which the rotational viscosity was 1000 poise was measured to determine the 1000 poise temperature.

Next, the glass cullet described above was pulverized, and 40 g of the glass particles having a particle diameter in the range of 0.5 to 1.5 mm were placed in a platinum boat of 180 × 20 × 15 mm and heated in a tubular electric furnace provided with a temperature gradient in the range of 900 to 1400°C for 8 hours or more, then taken out of the tubular electric furnace, and observed with a polarized light microscope to identify the position at which crystals derived from glass (devitrified) began to precipitate. The temperature inside the tubular electric furnace was actually measured using a type B thermocouple to determine the temperature of the position at which the precipitation began, which temperature was taken as the liquid phase temperature.

Next, the working temperature range $\Delta T$ ($\Delta T$ = 1000 poise temperature - liquid phase temperature) was calculated from the 1000 poise temperature and the liquid phase temperature measured by the above methods. The working temperature range was evaluated as "A" when $\Delta T$ was in the range of 100°C or more, the working temperature range was evaluated as "B" when ΔT was in the range of 30°C or more and less than 100°C, and the working temperature range was evaluated as "C" when ΔT was in the range of less than 30°C.

[Water resistance]

The completely same method as that in evaluation of the biosolubility was used to produce 1.0 g of a glass fiber sample having a filament diameter of 13.0 μm. Next, the mass reduction rate of the glass fiber sample was determined by measurement before and after immersion of the glass fiber sample in water at a temperature of 80°C for 24 hours.
Next, the water resistance was evaluated as "A" when the mass reduction rate measured by the above method was in the range of less than 1.0% by mass, and the water resistance was evaluated as "B" when the mass reduction rate measured by the above method was in the range of 1.0% by mass or more.

[Phase separation]

The phase separation was evaluated as "A" when the appearance observed of the glass bulk for dielectric tangent measurement was transparent, or almost transparent with slight clouding, and the phase separation was evaluated as "B" when the appearance was clouded, but allowed for light penetration, or was clouded.

[Table 1]

| | Example 1 | Example 2 | Example 3 | Example 4 | Example 5 | Example 6 |
|---|---|---|---|---|---|---|
| $SiO_2$ (% by mass; S) | 44.2 | 42.2 | 46.4 | 46.3 | 46.7 | 44.4 |
| $Al_2O_3$ (% by mass; A) | 18.5 | 19.5 | 17.5 | 17.5 | 17.2 | 17.6 |
| $B_2O_3$ (% by mass; B) | 23.9 | 23.9 | 25.8 | 23.9 | 27.0 | 26.7 |
| MgO (% by mass; M) | 2.1 | 2.1 | 2.1 | 3.1 | 2.1 | 1.0 |
| CaO (% by mass; C) | 5.1 | 5.1 | 4.1 | 5.1 | 4.1 | 4.1 |
| $P_2O_5$ (% by mass; P) | 6.2 | 7.2 | 4.1 | 4.1 | 2.9 | 6.2 |
| $TiO_2$ (% by mass) | 0.0 | 0.0 | 0.0 | 0.0 | 0.0 | 0.0 |
| MgO+CaO (% by mass) | 7.2 | 7.2 | 6.2 | 8.2 | 6.2 | 5.2 |
| Total | 100.0 | 100.0 | 100.0 | 100.0 | 100.0 | 100.0 |
| (C+M)/(S/P) | 1.00 | 1.23 | 0.55 | 0.73 | 0.38 | 0.72 |
| S×(C+M)/(A+B) | 7.5 | 7.0 | 6.6 | 9.2 | 6.5 | 5.2 |
| (S/P)×(C+M)/(A+B) | 1.22 | 0.97 | 1.61 | 2.24 | 2.25 | 0.84 |
| Biosolubility | OK | OK | OK | OK | OK | OK |
| Dielectric tangent | OK | OK | OK | OK | OK | OK |
| Working temperature range | A | A | A | A | A | B |
| Water resistance | A | A | A | A | B | B |
| Phase separation | A | A | A | B | B | B |

[Table 2]

| | Comparative Example 1 | Comparative Example 2 | Comparative Example 3 | Comparative Example 4 | Comparative Example 5 | Reference Example |
|---|---|---|---|---|---|---|
| $SiO_2$ (% by mass; S) | 42.0 | 41.8 | 42.8 | 46.4 | 46.3 | 40.9 |
| $Al_2O_3$ (% by mass; A) | 19.4 | 19.4 | 23.2 | 19.6 | 19.5 | 23.1 |
| $B_2O_3$ (% by mass; B) | 20.7 | 17.5 | 25.8 | 25.8 | 23.9 | 19.0 |

(continued)

| | Comparative Example 1 | Comparative Example 2 | Comparative Example 3 | Comparative Example 4 | Comparative Example 5 | Reference Example |
|---|---|---|---|---|---|---|
| MgO (% by mass; M) | 2.0 | 2.0 | 2.1 | 2.1 | 3.1 | 0.0 |
| CaO (% by mass; C) | 5.1 | 5.1 | 4.1 | 4.1 | 5.1 | 17.0 |
| $P_2O_5$ (% by mass; P) | 10.7 | 14.3 | 2.1 | 2.1 | 2.1 | 0.0 |
| $TiO_2$ (% by mass) | 0.0 | 0.0 | 0.0 | 0.0 | 0.0 | 0.0 |
| MgO+CaO (% by mass) | 7.2 | 7.1 | 6.2 | 6.2 | 8.2 | 17.0 |
| Total | 100.0 | 100.0 | 100.0 | 100.0 | 100.0 | 100.0 |
| (C+M)/(S/P) | 1.83 | 2.44 | 0.30 | 0.27 | 0.37 | - |
| S×(C+M)/(A+B) | 7.5 | 8.1 | 5.4 | 6.3 | 8.8 | 16.5 |
| (S/P)×(C+M)/(-A+B) | 0.70 | 0.57 | 2.62 | 3.07 | 4.26 | - |
| Biosolubility | OK | OK | OK | OK | NG | OK |
| Dielectric tangent | OK | OK | OK | OK | NG | NG |
| Working temperature range | C | C | C | C | B | A |
| Water resistance | A | B | A | A | A | A |
| Phase separation | A | B | A | A | A | A |

As seen in Table 1, the glass compositions for glass fibers of Examples 1 to 6, including $SiO_2$ in the range of 36.0% by mass or more and less than 48.0% by mass, $B_2O_3$ in the range of 18.0% by mass or more and 32.0% by mass or less, $Al_2O_3$ in the range of 12.0% by mass or more and 24.0% by mass or less, $P_2O_5$ in the range of 2.5% by mass or more and 8.9% by mass or less, and CaO and MgO in the range of 5.0% by mass or more and 13.0% by mass or less in total, with respect to the total amount, have a total elution rate of four components of Si, B, Al and Ca of 110 µg/h or more, a working temperature range of 30°C or more, and a dielectric tangent of less than 0.0030, and on formation of glass fiber, comprise biosolubility, can achieve long fiber formation, and can also comprise a low dielectric tangent.

In contrast, as seen in Table 2, the glass compositions for glass fibers of Comparative Examples 1 to 5 and Reference Example, including $SiO_2$ in the range of 36.0% by mass or more and less than 48.0% by mass, $B_2O_3$ in the range of 18.0% by mass or more and 32.0% by mass or less, $Al_2O_3$ in the range of 12.0% by mass or more and 24.0% by mass or less, and CaO and MgO in the range of 5.0% by mass or more and 13.0% by mass or less in total, with respect to the total amount, in which the content of $P_2O_5$ is less than 2.5% by mass or more than 8.9% by mass, cause one of or a plurality of failures: the working temperature range is less than 30°C and on formation of glass fiber, long fiber formation is difficult; the dielectric tangent is 0.0030 or more and on formation of glass fiber, a low dielectric tangent cannot be comprised; or on formation of glass fiber, the total elution rate of Si, B, Al and Ca, as measured by the above method, is 110 µg/h or less and on formation of glass fiber, biosolubility cannot be comprised.

The glass composition for glass fiber of Reference Example is the glass composition described in Japanese Patent Application No. 2020-213162, and is different from the invention according to claim 1 of the present invention in that the content of $P_2O_5$ with respect to the total amount is 0.0% by mass and is different from the invention according to claims 2 to 5 of the present invention in that the content of $P_2O_5$ with respect to the total amount is 0.0% by mass not to enable the formulae (1-1), (2-1), (2-2), and (2-3) to be defined. As seen in Table 2, glass fiber obtained from the glass composition for glass fiber of Reference Example comprises biosolubility and can achieve long fiber formation, but cannot comprise a sufficiently low dielectric tangent.

**Claims**

1. A glass composition for glass fiber, comprising:

   $SiO_2$ in a range of 36.0% by mass or more and less than 48.0% by mass;
   $B_2O_3$ in a range of 18.0% by mass or more and 32.0% by mass or less;
   $Al_2O_3$ in a range of 12.0% by mass or more and 24.0% by mass or less;
   $P_2O_5$ in a range of 2.5% by mass or more and 8.9% by mass or less; and
   CaO and MgO in a range of 5.0% by mass or more and 13.0% by mass or less in total,

   with respect to a total amount.

2. The glass composition for glass fiber according to claim 1, wherein a content S of $SiO_2$, a content P of $P_2O_5$, a content C of CaO and a content M of MgO satisfy the following formula (1-1):

$$0.38 \leq (C + M)/(S/P) \leq 1.52 \dots (1\text{-}1)$$

3. The glass composition for glass fiber according to claim 1, wherein a content S of $SiO_2$, a content B of $B_2O_3$, a content A of $Al_2O_3$, a content P of $P_2O_5$, a content C of CaO and a content M of MgO satisfy the following formula (2-1):

$$0.91 \leq (S/P) \times (C + M)/(A + B) \leq 2.31 \dots (2\text{-}1)$$

4. The glass composition for glass fiber according to claim 1, wherein the S, B, A, P, C and M satisfy the following formula (2-2):

$$0.92 \leq (S/P) \times (C + M)/(A + B) \leq 2.24 \dots (2\text{-}2)$$

5. The glass composition for glass fiber according to claim 1, wherein the S, B, A, P, C and M satisfy the following formula (2-3):

$$0.93 \leq (S/P) \times (C + M)/(A + B) \leq 1.92 \dots (2\text{-}3)$$

6. Glass fiber comprising glass filaments formed of the glass composition for glass fiber according to claim 1.

7. The glass fiber according to claim 6, wherein a filament diameter of each of the glass filaments is less than 3.0 $\mu$m.

8. A glass fiber woven fabric comprising the glass fiber according to claim 6 or claim 7.

9. A glass fiber-reinforced resin composition comprising the glass fiber according to claim 6 or claim 7.

**Patentansprüche**

1. Glaszusammensetzung für Glasfasern, umfassend:

   $SiO_2$ in einem Bereich von 36,0 Gew.-% oder mehr und weniger als 48,0 Gew.-%,
   $B_2O_3$ in einem Bereich von 18,0 Gew.-% oder mehr und 32,0 Gew.-% oder weniger,
   $Al_2O_3$ in einem Bereich von 12,0 Gew.-% oder mehr und 24,0 Gew.-% oder weniger,
   $P_2O_5$ in einem Bereich von 2,5 Gew.-% oder mehr und 8,9 Gew.-% oder weniger, und CaO und MgO in Summe in einem Bereich von 5,0 Gew.-% oder mehr und 13,0 Gew.-% oder weniger,
   bezogen auf die Gesamtmenge.

2. Glaszusammensetzung für Glasfasern gemäß Anspruch 1, wobei ein Gehalt S an $SiO_2$, ein Gehalt P an $P_2O_5$, ein Gehalt C an CaO und ein Gehalt M an MgO die folgende Formel (1-1) erfüllen:

$$0,38 \leq (C + M)/(S/P) \leq 1,52 \ ... \ (1\text{-}1)$$

**3.** Glaszusammensetzung für Glasfasern gemäß Anspruch 1, wobei ein Gehalt S an $SiO_2$, ein Gehalt B an $B_2O_3$, ein Gehalt A an $Al_2O_3$, ein Gehalt P an $P_2O_5$, ein Gehalt C an CaO und ein Gehalt M an MgO die folgende Formel (2-1) erfüllen:

$$0,91 \leq (S/P) \times (C + M)/(A + B) \leq 2,31 \ ... \ (2\text{-}1)$$

**4.** Glaszusammensetzung für Glasfasern gemäß Anspruch 1, wobei S, B, A, P, C und M die folgende Formel (2-2) erfüllen:

$$0,92 \leq (S/P) \times (C + M)/(A + B) \leq 2,24 \ ... \ (2\text{-}2)$$

**5.** Glaszusammensetzung für Glasfasern gemäß Anspruch 1, wobei S, B, A, P, C und M die folgende Formel (2-3) erfüllen:

$$0,93 \leq (S/P) \times (C + M)/(A + B) \leq 1,92 \ ... \ (2\text{-}3)$$

**6.** Glasfaser, die Glasfilamente umfasst, die aus der Glaszusammensetzung für Glasfasern gemäß Anspruch 1 gebildet sind.

**7.** Glasfaser gemäß Anspruch 6, wobei ein Filamentdurchmesser jedes der Glasfilamente weniger als 3,0 $\mu$m beträgt.

**8.** Glasfasergewebe, das die Glasfaser gemäß Anspruch 6 oder Anspruch 7 umfasst.

**9.** Glasfaserverstärkte Harzzusammensetzung, die die Glasfaser gemäß Anspruch 6 oder Anspruch 7 umfasst.

**Revendications**

**1.** Composition de verre pour fibre de verre, comprenant :

du $SiO_2$ dans une plage de 36,0 % en masse ou plus et inférieure à 48,0 % en masse ;
du $B_2O_3$ dans une plage de 18,0 % en masse ou plus et 32,0 % en masse ou moins ;
du $Al_2O_3$ dans une plage de 12,0 % en masse ou plus et 24,0 % en masse ou moins ;
du $P_2O_5$ dans une plage de 2,5 % en masse ou plus et 8,9 % en masse ou moins ; et
du CaO et du MgO au total dans une plage de 5,0 % en masse ou plus et 13,0 % en masse ou moins,
par rapport à la quantité totale.

**2.** Composition de verre pour fibre de verre selon la revendication 1, dans laquelle une teneur S en $SiO_2$, une teneur P en $P_2O_5$, une teneur C en CaO et une teneur M en MgO satisfont la formule suivante (1-1) :

$$0,38 \leq (C + M)/(S/P) \leq 1,52 \ ... \ (1\text{-}1).$$

**3.** Composition de verre pour fibre de verre selon la revendication 1, dans laquelle une teneur S en $SiO_2$, une teneur B en $B_2O_3$, une teneur A en $Al_2O_3$, une teneur P en $P_2O_5$, une teneur C en CaO et une teneur M en MgO satisfont la formule suivante (2-1) :

$$0,91 \leq (S/P) \times (C + M)/(A + B) \leq 2,31 \ ... \ (2\text{-}1).$$

**4.** Composition de verre pour fibre de verre selon la revendication 1, dans laquelle S, B, A, P, C et M satisfont la formule suivante (2-2) :

$$0{,}92 \leq (S/P) \times (C + M)/(A + B) \leq 2{,}24 \ldots (2\text{-}2).$$

5. Composition de verre pour fibre de verre selon la revendication 1, dans laquelle S, B, A, P, C et M satisfont la formule suivante (2-3) :

$$0{,}93 \leq (S/P) \times (C + M)/(A + B) \leq 1{,}92 \ldots (2\text{-}3).$$

6. Fibre de verre comprenant des filaments de verre formés à partir de la composition de verre pour fibre de verre selon la revendication 1.

7. Fibre de verre selon la revendication 6, dans laquelle un diamètre de filament de chacun des filaments de verre est inférieur à 3,0 μm.

8. Tissu en fibre de verre comprenant la fibre de verre selon la revendication 6 ou la revendication 7.

9. Composition de résine renforcée par des fibres de verre comprenant la fibre de verre selon la revendication 6 ou la revendication 7.

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2020213162 A
- JP 6927463 B
- WO 2018125736 A

**Non-patent literature cited in the description**

- **K. SEBASTIAN. et al.** *Glass Science and Technology*, 2002, vol. 75, 263-270